# EUROPEAN PATENT APPLICATION

(11) **EP 2 804 179 A1**
(43) Date of publication of application: **19.11.2014**
(21) Application number: 13305644.0
(22) Date of filing: 17.05.2013
(51) Int. Cl.: G11C 5/00, H03K 3/037, H03K 3/356, H03L 7/089

(54) **Radiation hardened circuit**

(71) Applicant: STMicroelectronics (Crolles 2) SAS, 38920 Crolles (FR); STMicroelectronics Pvt. Ltd, Greater Noida 201 308, Uttar Pradesh (IN); Centre National de la Recherche Scientifique, 75794 Paris Cedex 16 (FR); Université d'Aix-Marseille, 13284 Marseille Cedex 07 (FR)
(72) Inventor: Gasiot, Gilles, 38170 Seyssinet-Pariset (FR); Clerc, Sylvain, 38000 Grenoble (FR); Yousuf, Junaid, 190006 Srinagar (IN); Glorieux, Maximilien, 38000 Grenoble (FR)
(74) Representative: Thibon, Laurent

(57) **Abstract**

The invention concerns a circuit comprising: a data storage element (102); first and second input circuitry (104, 104') coupled respectively to first and second inputs (IN1, IN2) of the data storage element and each comprising a plurality of components adapted to generate, as a function of an initial signal (IN), first and second input signals respectively provided to said first and second inputs; wherein the data storage element comprises a first storage node and is configured such that a voltage state stored at said first storage node is protected from a change in only one of said first and second input signals by being determined by the conduction state of a first transistor coupled to the first storage node and controlled based on said first input signal and by the conduction state of a second transistor coupled to the first storage node and controlled based on said second input signal.

## Description

### FIELD

The present disclosure relates to a radiation hardened circuit and to a method of protecting a circuit from radiation.

### BACKGROUND

Integrated circuits are generally sensitive to ionizing particles, which can induce parasitic currents in the integrated circuit. In certain cases, these parasitic currents can be enough to flip the binary state of a data storage element in the circuit, such as a latch. Furthermore, such currents can induce a transient in combinational logic or at low capacitance analog nodes.

There are various known techniques for hardening devices against radiation. For example, integrated circuits can be protected to some extent from certain types of radiation by resistant covers. Furthermore, it has also been proposed to provide radiation hardened memories, such as the one described in United States patent US 5,570,313, which protect the memories and subsequent elements from radiation hitting its transistors.

However, for certain circuits, such as phase locked loops (PLL), which are relatively complex, it would be impractical to harden each circuit element against radiation using the known techniques above. There is thus a need for an alternative radiation hardening solution that is effective and simple to implement.

### SUMMARY

It is the name of embodiments of the present disclosure to at least partially address one or more needs in the prior art.

According to one aspect, there is provided a circuit comprising: a data storage element; first input circuitry coupled to a first input of the data storage element and comprising a first plurality of components adapted to generate, as a function of an initial signal, a first input signal provided to said first input; second input circuitry coupled to a second input of the data storage element and comprising a second plurality of components adapted to generate, as a function of said initial signal, a second input signal provided to said second input, the second input circuitry being functionally equivalent to the first input circuitry; wherein the data storage element comprises a first storage node, and wherein said data storage element is configured such that a voltage state stored at said first storage node is protected from a change in only one of said first and second input signals by being determined by the conduction state of a first transistor coupled to the first storage node and controlled based on said first input signal and by the conduction state of a second transistor coupled to the first storage node and controlled based on said second input signal.

According to one embodiment, the first transistor is coupled by its main current nodes between said first storage node and a first supply voltage and has its control node coupled to said first input; and the second transistor is coupled by its main current nodes between said first storage node and a second supply voltage and has its control node coupled to said second input.

According to one embodiment, the circuit further comprises a second storage node configured to store a voltage state determined by the conduction state: of a third transistor coupled between the second storage node and the first supply voltage and controlled based on said first input signal; and of a fourth transistor coupled between the second storage node and said second supply voltage and controlled based on said second input signal.

According to one embodiment, the circuit further comprises: a third storage node coupled: to the control node of said first transistor; to said first supply voltage by the main current nodes of a fifth transistor; and to said second supply voltage by the main current nodes of a sixth transistor, a control node of the fifth transistor being coupled to the second storage node and a control node of the sixth transistor being coupled to the first storage node; and a fourth storage node coupled: to said control node of said second transistor; to said first supply voltage by the main current nodes of a seventh transistor; and to said second supply voltage by the main current nodes of an eighth transistor, a control node of the seventh transistor being coupled to the first storage node and a control node of the eighth transistor being coupled to the second storage node.

According to one embodiment, the first and second input signals are each one of: a data signal; a clock signal; a reset signal; and a set signal.

According to one embodiment, the data storage element is a synchronous data storage element, the first and second inputs being data inputs of said synchronous data storage element, and wherein the control node of said first transistor is coupled to said first input via a first switch controlled by a first clock signal, and the control node of said second transistor is coupled to said second input via a second switch controlled by a second clock signal.

According to one embodiment, the circuit further comprises: first clock input circuitry coupled to a first clock input of the synchronous data storage element and adapted to provide a first clock signal to said first clock input based on an initial input clock signal; second clock input circuitry coupled to a second clock input of said synchronous data storage element and adapted to provide a second clock signal to said second clock input based on said initial input clock signal.

According to one embodiment, the data storage element is a synchronous data storage element, the first input being a first clock input and said second input being a second clock input, and wherein: the control node of said first transistor is coupled to one of the main current nodes of a ninth transistor, a control node of said ninth transistor being coupled to said first clock input; and the control node of said second transistor is coupled to one of the main current nodes of a tenth transistor, a control node of said tenth transistor being coupled to said second clock input.

According to a further aspect, there is provided a circuit comprising: an analog circuit block; first input circuitry coupled to a first input of the analog circuit block and comprising a first plurality of components adapted to generate, as a function of an initial signal, a first input signal provided to said first input; second input circuitry coupled to a second input of the analog circuit block and comprising a second plurality of components adapted to generate, as a function of said initial signal, a second input signal provided to said second input, the second input circuitry being functionally equivalent to the first input circuitry; wherein the analog circuit block comprises an output node, said output node being protected from a change in only one of said first and second input signals by being coupled to a first supply voltage via first and second transistors and to a second supply voltage via third and fourth transistors, said first and third transistors being controlled based on said first input signal, and said second and fourth transistors being controlled based on said second input signal.

According to one embodiment, the analog circuit block is a charge pump.

According to one embodiment, the first and second transistors are coupled in series with each other, and the third and fourth transistors are coupled in series with each other.

According to one embodiment, the first and second transistors are coupled in parallel with each other, and the third and fourth transistors are coupled in parallel with each other.

According to a further aspect, there is provided a phase locked loop comprising any of the above circuits.

According to a further aspect, there is provided a method of protecting first input circuitry of a data storage element from radiation comprising: generating, by the first input circuitry comprising a first plurality of components, a first input signal as a function of an initial signal; generating, by second input circuitry comprising a second plurality of components, a second input signal as a function of said initial signal, the second input circuitry being functionally equivalent to the first input circuitry; and wherein a voltage state stored by a first storage node of said data storage element is protected from a change in only one of said first and second input signals by being determined by the conduction state of a first transistor coupled to the first storage node and controlled based on said first input signal and of a second transistor coupled to the first storage node and controlled based on said second input signal.

According to a further aspect, there is provided a method of protecting first input circuitry of an analog circuit block from radiation comprising: generating, by the first input circuitry comprising a first plurality of components, a first input signal as a function of an initial signal; generating, by second input circuitry comprising a second plurality of components, a second input signal as a function of said initial signal, the second input circuitry being functionally equivalent to the first input circuitry; and generating an output signal at a first output node of the analog circuit block, wherein said output signal is protected from a change in only one of said first and second input signals by being coupled to a first supply voltage via first and second transistors and to a second supply voltage via third and fourth transistors, said first and third transistors being controlled based on said first input signal, and said second and fourth transistors being controlled based on said second input signal.

### BRIEF DESCRIPTION OF THE DRAWINGS

The foregoing and other purposes, features, aspects and advantages of the embodiments described herein will become apparent from the following detailed description, given by way of illustration and not limitation with reference to the accompanying drawings, in which:
Figure 1A schematically illustrates a radiation hardened circuit according to an example embodiment of the present disclosure;
Figure 1B schematically illustrates the radiation hardened circuit of Figure 1A in more detail according to an example embodiment of the present disclosure;
Figure 2 is a timing diagram showing signals in the circuit of Figure 1B according to the example embodiment of the present disclosure;
Figure 3 schematically illustrates a radiation hardened circuit according to a further embodiment of the present disclosure;
Figure 4 schematically illustrates a synchronous data storage element of the circuit of Figure 3 in more detail according to an example embodiment of the present disclosure;
Figure 5 schematically illustrates a phase locked loop (PLL) according to an example embodiment of the present disclosure;
Figure 6 schematically illustrates a phase frequency detector of the PLL of Figure 5 in more detail according to an example embodiment of the present disclosure;
Figure 7 schematically illustrates feedback circuitry of the PLL of Figure 5 in more detail according to an example embodiment of the present disclosure;
Figure 8A schematically illustrates a charge pump of the PLL of Figure 5 in more detail according to an example embodiment of the present disclosure;
Figure 8B schematically illustrates the charge pump of the PLL of Figure 5 in more detail according to a further example embodiment of the present disclosure;
Figure 8C schematically illustrates circuitry for generating control signals of the charge pump of Figure 8B according to an example embodiment of the present disclosure;
Figure 8D schematically illustrates a charge pump of the PLL of Figure 5 in more detail according to yet a further example embodiment of the present disclosure; and
Figure 9 schematically illustrates an analog lock detection block of the PLL of Figure 5 in more detail according to an example embodiment of the present disclosure.

### DETAILED DESCRIPTION OF EN1BODIMENTS OF THE PRESENT DISCLOSURE

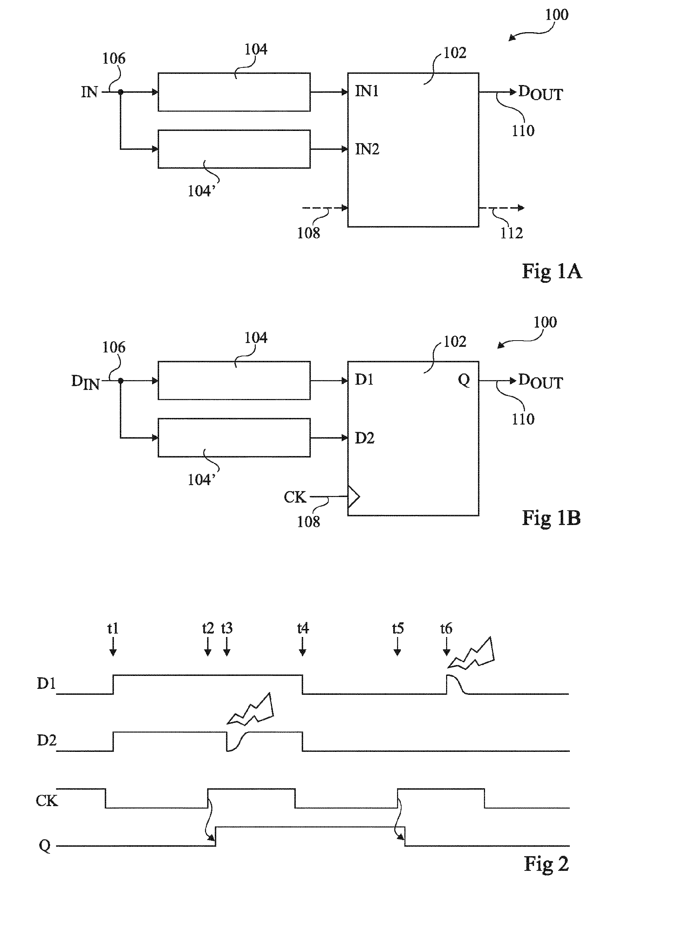

Figure 1A illustrates a radiation hardened circuit 100 comprising a circuit block 102 having inputs IN1 and IN2.

The data input IN1 is coupled to and driven by input circuitry 104, which receives an input signal IN on a line 106. The input circuitry 104 comprises a plurality of components, for example logic components and/or analog components, that generates the signal at input IN1 as a function of the input signal IN. According to one example, the input circuitry 104 comprises combinational components, such as data buffers or other logic gates and not sequential logic. According to another example, the input circuitry 104 additionally or alternatively comprises one or more analog circuit components such as resistors, capacitors, inductors, transmission lines, etc. In any case, the input circuitry 104 for example does not store data from one clock cycle to the next.

The data input IN2 is coupled to and driven by input circuitry 104', which is for example an identical duplication of the input circuitry 104, or is at least functionally equivalent to input circuitry 104, and receives the same input signal IN as the input circuitry 104.

The circuit block 102 for example comprises one or more further inputs 108. Furthermore, the circuit block 102 comprises an output 110 providing an output signal OUT, and for example comprises one or more further outputs 112.

In operation, in response to at least one voltage or current change of both of the input signals at inputs IN1 and IN2, the circuit block 102 is for example adapted to apply, immediately or after a time delay, a change of the output signal D_{OUT}. However, for changes that occur at only one of the inputs IN1 or IN2, indicating the presence of radiation, the output signal is to at least some extent protected. In particular, as will be described in more detail below, the output signal is determined by the conduction state of at least two transistors (not illustrated in Figure 1), one being controlled based on the signal at input IN1, and the other being controlled based on the signal at input 1N2. In this way, at least some changes in the conduction state of only one of the transistors will be countered by the other transistor.

Figure 1B illustrates the radiation hardened circuit 100 according to a particular example in which the circuit block 102 is a data storage element 102, having data inputs D1 and D2. The data storage element 102 is for example a synchronous data storage element, receiving a clock signal CK on input line 108. Element 102 provides an output data signal D_{OUT} on output line 110.

In operation, the synchronous data storage element 102 maintains a voltage state on which the output data D_{OUT} is based. The data storage element 102 is for example configured such that this logic state can not be altered as a result of radiation hitting any one of its transistors.

Furthermore, the voltage state stored by the data storage element 102 is also protected from being altered as a result of radiation hitting the input circuitry 104. In particular, by duplicating the circuitry 104 to provide the input circuitry 104', it is very unlikely that both of the input signals D1 and D2 will be affected by radiation hitting the circuit at the same time. The data storage element 102 is configured such that its stored voltage state is not modified by a change in just one of the data signals D1 and D2.

Figure 2 is a timing diagram illustrating examples of the input data signals D1 and D2, the clock signal CK, and the output data signal Q of the synchronous data storage element 102 of Figure 1B. It is assumed that all of the data signals D1, D2 and Q for example start low.

At a time t1, both of the data signals D1 and D2 for example transition to a logic high state at substantially the same time, in response to a change in the input data signal D_{IN}. The clock signal CK for example transitions low shortly beforehand, which does not cause any transition on the Q output.

At a time t2, a rising edge of the clock signal CK occurs, which triggers shortly afterwards a change in the Q data output of the element 102. In this example, it is assumed that the data storage element 102 is a D-type latch, the Q data output following the input data when the clock signal is high. However, it will be apparent to those skilled in the art that element 102 could perform any of a wide range of alternative functions. For example, element 102 could be a latch that is transparent when the clock is low, a JK flip-flop, an SR flip-flop, or a more complex device. The device could also be a D-type flip-flop comprising for example two latches coupled in series, these latches being transparent during opposite phases of the clock signal.

At a time t3, shortly after the rising edge of the clock signal CK, and while the clock signal CK is still high, an ionizing particle for example hits the input circuitry 104', causing a transient of the data signal D2 from a logic high level to a logic low level. However, because data signal D1 is unaffected, the voltage state of the data storage element 102, and thus its Q output, is not modified by this transient. The data value of the signal D2 for example recovers a short time later to the high state, as determined by the value of the input data D_{IN}. Thus the transient results in no permanent modification of the data in the circuit.

At a time t4, the data signals D1 and D2 both transition to a low state due to a change in the logic state of D_{IN}. The clock signal CK for example comprises a falling edge shortly beforehand, which does not cause any transition on the Q output.

At a time t5, the clock signal CK goes high again, this rising edge for example causing the Q signal to go low a short time later, reflecting the low level of the data signals D1 and D2.

At a time t6, an ionizing particle for example hits the input circuitry 104, causing a transient of the data signal D1, which goes from the logic low state to a logic high state. However, because the data signal D2 does not change state, the voltage state stored by the synchronous element 102 is not altered, and instead the data signal D1 recovers a short time later to the low state, as determined by the value of D_{IN}.

Thus the data storage element 102 is protected from transients occurring at its data inputs.

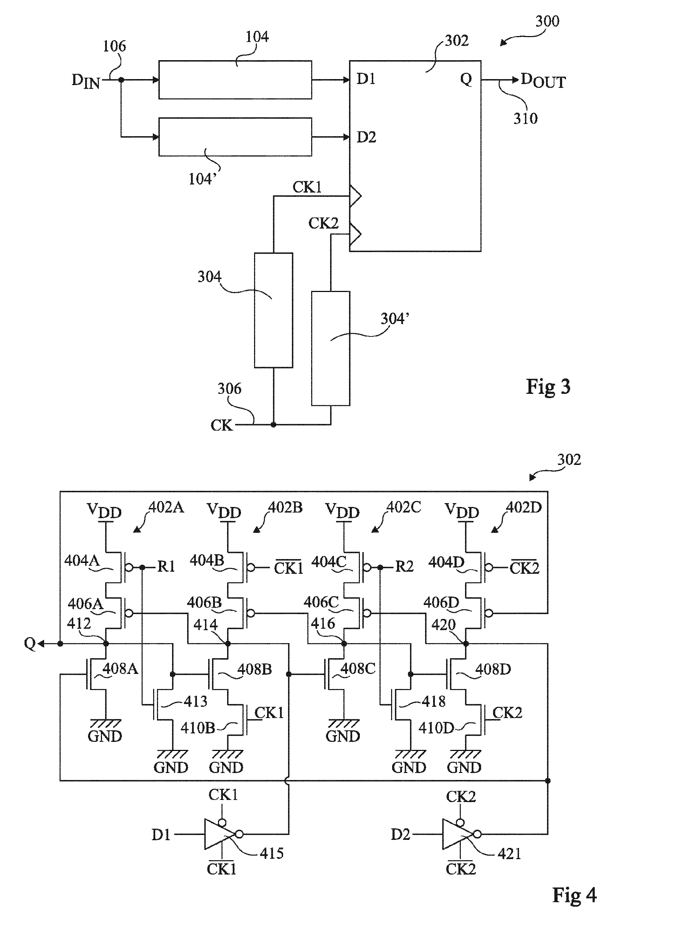

Figure 3 illustrates a radiation hardened circuit 300 according to an alternative embodiment to that of Figure 1B. Those features in common with the circuit 100 of Figure 1B are labelled with like reference numerals and will not be described again in detail.

The circuit 300 comprises a data storage element 302, which is similar to the data storage element 102 of Figure 1B, but comprises, in addition to the data inputs D1 and D2, a pair of clock inputs CK1 and CK2. The clock input CK1 is coupled to clock input circuitry 304, which receives an input clock signal CK on an input line 306. Circuitry 304 for example comprises one or more clock buffers and/or other logic devices, such as combinational gates and/or sequential elements including clock gating latches. The clock input CK2 is coupled to clock input circuitry 304', which also receives the input clock signal CK on line 306. Circuitry 304' is for example identical to circuitry 304, or at least functionally equivalent.

In operation, as with the circuit 100 of Figure 1B, the voltage state of the data storage element 302 is protected from radiation hitting the input circuitry 104 or 104'. Furthermore, the data storage element 302 is additionally protected from radiation hitting the clock input circuitry 304 or 304'. The data storage element 302 is for example configured to modify its stored voltage state based on the input data signals D1 and D2 only when both of the signals CK1 and CK2 transition towards the same state, for example to a logic high state.

In an alternative embodiment, only the clock input circuitry 304 in circuit 300 is protected from radiation, and the data input circuitry 104' is omitted, the data storage element 302 comprising a single data input D.

Figure 4 illustrates the data storage element 302 of Figure 3 in more detail according to an example embodiment.

Element 302 for example comprises four main branches 402A, 402B, 402C and 402D. Branch 402A comprises PMOS transistors 404A and 406A and an NMOS transistor 408A coupled in series between a supply voltage V_{DD} and ground. Branch 402B comprises PMOS transistors 404B and 406B and NMOS transistors 408B and 410B coupled between supply voltage V_{DD} and ground. Branch 402C comprises PMOS transistors 404C and 406C and an NMOS transistor 408C coupled in series between supply voltage V_{DD} and ground. Branch 402D comprises PMOS transistors 404D and 406D and NMOS transistors 408D and 410D coupled in series between supply voltage V_{DD} and ground.

A node 412 between the transistors 406A and 408A of branch 402A provides the data output signal Q of the data storage element 302. Node 412 is also coupled to the gate node of transistor 408B of the branch 402B, to the gate node of transistor 406D of the branch 402D, and to ground via a transistor 413. The gates of transistors 413 and 404A receive a reset signal R1.

A node 414 between the transistors 406B and 408B of the branch 402B receives the data input signal D1 via a switch 415 controlled by the clock signal CK1. In the example of Figure 4, this switch is implemented by an inverter powered when the clock signal CK1 is low and its inverse C̅K̅1 is high. Node 414 is also coupled to the gate of transistor 406A of branch 402A, and of transistor 408C of branch 402C. The gates of transistors 404B and 410B are coupled respectively to the clock signals C̅K̅1 and CK1.

A node 416 between the transistors 406C and 408C of branch 402C is coupled to the gate nodes of transistor 406B of branch 402B and transistor 408D of branch 402D. Node 416 is also coupled to ground via a further transistor 418. The gate nodes of transistors 404C and 418 receive a second reset signal R2.

A node 420 between the transistors 406D and 408D of the branch 402D is coupled to the gate of transistor 406C of branch 402C and to the gate of transistor 408A of branch 402A. Node 420 also receives the data signal D2 via a switch 421. Switch 421 is for example identical to switch 415, except that it is activated by the clock signal CK2 and its inverse C̅K̅2̅. The gate nodes of transistors 404D and 410D are coupled to the clock signals C̅K̅2̅ and CK2 respectively.

While the output signal Q of the element 302 is provided by node 412, in alternative embodiments it could be provided by node 416. Furthermore, in some embodiments both of the nodes 412 and 416 could be used to provide identical output data, which could for example be provided to the data inputs of a subsequent pair of combinational logic networks such as blocks 104 and 104' of Figure 3.

The data storage element 302 of Figure 4 stores data in the form of high or low voltage states at nodes 412, 414, 416 and 420. It will be noted that, in the circuit of Figure 4, the voltage states at nodes 412, 414, 416 and 420 are determined by both the signals D1 and D2 when the inverters 415 and 421 are activated. In particular, transistor 406A is controlled by signal D1 at node 414, and transistor 408A is controlled by the signal D2 at node 420. Therefore, a transient change in one of the signals D1, D2 alone is not sufficient to change the voltage at these nodes. Similarly, a transient at node 414 or 420 caused by a transient of one of the clock signals CK1 or CK2 will not alone cause a change in the voltage state stored at nodes 412, 414, 416 and 420.

During normal functioning of the data storage element 302, both of the reset signals R1 and R2 are for example at a logic low level. Both of the reset signals R1 and R2 are asserted high to reset the data stored at the storage nodes 412 and 416 to a low level. If only one of the reset signals is asserted however, the reset will not be effective. Thus any transient occurring on only one of the reset lines will not cause a reset of the data storage element 302.

It will be apparent to those skilled in the art how the data storage element of Figure 4 could be adapted to implement the data storage element 102 of Figure 1B. For example, the clock signals CK1 and CK2 can be replaced by the same clock signal CK. Furthermore, it will be apparent to those skilled in the art how this data storage element 302 could be adapted to protect the stored states only from transients in the clock path. For example, the data signals D1 and D2 could both be replaced by a single data input D applied to each of the switches 415 and 421. Similarly, the reset signals R1 and R2 could be both replaced by a single reset signal applied to each of the transistors 404A, 413, 404C and 418.

Furthermore, it will be apparent to those skilled in the art how this data storage element 302 could be adapted so that it is controlled by set signals S1 and S2 rather than, or in addition to, the reset signals R1 and R2. For example, instead of or in addition to PMOS transistor 404A and NMOS transistor 413, a PMOS transistor could be coupled in parallel with transistor 406A and an NMOS transistor could be coupled in series with transistors 408B and 410B, these additional transistors being controlled by a set signal SN1. Similarly, instead of or in addition to PMOS transistor 404C and NMOS transistor 418, a PMOS transistor could be coupled in parallel with transistor 406C and an NMOS transistor could be coupled in series with transistors 408D and 410D, these additional transistors being controlled by a set signal SN2. In this way, the data stored at the storage nodes 412 and 416 can be set to a high level when the set signals SN1 and SN2 are low.

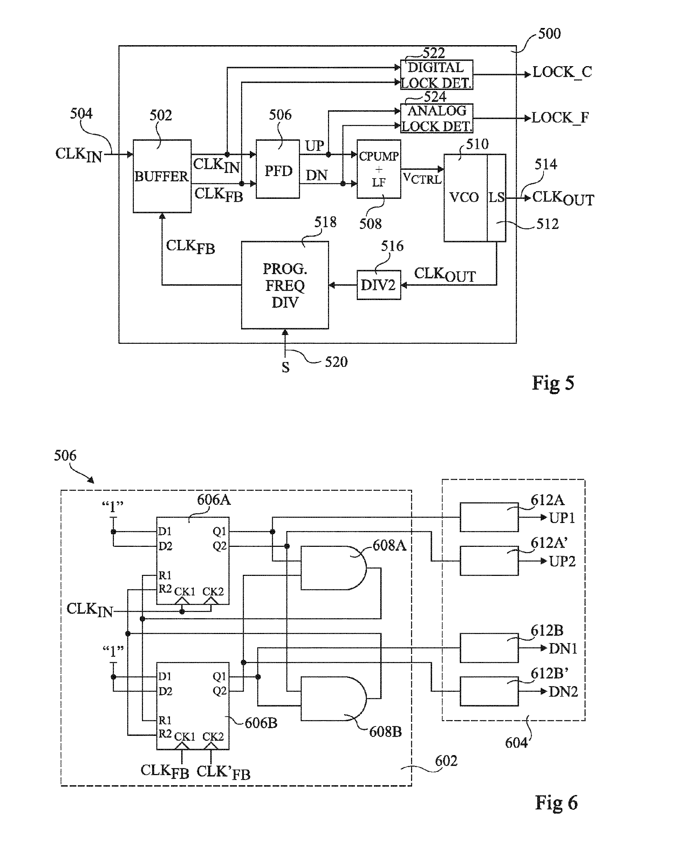

Figure 5 illustrates a phase locked loop circuit 500 according to an example embodiment in which radiation protection can be incorporated based on the techniques described herein above.

Circuit 500 comprises an input buffer 502, which receives on an input line 504 an input frequency signal CLK_{IN}. The buffer 502 also receives a feedback frequency signal CLK_{FB} via a feedback loop. Buffer 502 provides the input frequency signal CLK_{IN} and the feedback frequency signal CLK_{FB} to a phase frequency detector (PFD) 506, which compares these signals to generate analog up and down control signals UP and DN. The analog control signals UP and DN are provided to a charge pump and loop filter block 508, which generates an analog control voltage V_{CTRL} based on these signals. The control voltage V_{CTRL} is in turn provided to a voltage controlled oscillator (VCO) 510. A level shifter 512 is for example provided at the output of the VCO 510, and provides a frequency signal CLK_{OUT} on an output line 514.

The output signal CLK_{OUT} is also provided to the feedback path, which for example comprises a frequency divide-by-two block 516, and a programmable frequency divider 518. The divide-by-two block 516 for example reduces the frequency of the clock signal CLK_{OUT} by a factor of two, and provides the resulting signal to the programmable frequency divider 518. The programmable frequency divider 518 further divides the signal based on a control signal S, to provide the feedback signal CLK_{FB} provided to buffer 502.

Thus, in operation, the frequency of the output signal CLK_{OUT} of the PLL will converge to a value N times that of the input clock frequency CLK_{IN}, where N is equal to overall divisor resulting from the divisions performed by blocks 516 and 518.

A digital lock detection block 522 and an analog lock detection block 524 provide signals indicating when the output clock signal CLK_{OUT} has settled to a desired frequency and can be relied upon. The block 522 provides a coarse lock signal LOCK_C, which is based on a digital processing of the frequency signals CLK_{IN} and CLK_{FB}. The block 524 provides a fine lock signal LOCK_F, which is based on an analog and digital processing of the control signals UP and DN generated by the PFD 506.

The circuits of Figures 1A, 1B, 3 and/or 4 are for example incorporated in various parts of the PLL of Figure 4 in order to increase the immunity of this circuit from errors caused by radiation, as will now be described with reference to Figures 6 to 9.

Figure 6 illustrates schematically the phase frequency detector 506 of Figure 5 in more detail.

The PFD 506 for example comprises a detection stage 602, and an output stage 604.

The detection stage 602 comprises flip-flops 606A and 606B, each of which is similar to data storage element 302 of Figure 3. The flip-flop 606A receives at both of its clock inputs the frequency signal CLK_{IN}, while the flip-flop 606B receives at its clock inputs the frequency signals CLK_{FB} and CLK_{FB}' respectively. Both of the flip-flops 606A and 606B have their data inputs tied to a logic "1".

Each of the flip-flops 606A, 606B comprises a pair of duplicated outputs Q1 and Q2, which are coupled to the output stage 604, and also to two redundant two-input AND gates 608A and 608B of stage 602. In particular, the output Q1 of flip-flop 606A and the output Q2 from the flip-flop 606B are coupled to respective inputs of AND gate 608A, and the output Q2 of flip-flop 606A and the output Q1 from the flip-flop 606B are coupled to respective inputs of AND gate 608B. The output of AND gate 608A is coupled to a first reset input R1 of each of the flip-flops 606A, 606B, while the output of AND gate 608B is coupled to a second reset input R2 of each of the flip-flops 606A, 606B.

In operation, each of the flip-flops 606A and 606B are reset when both of the reset signals R1 and R2 are asserted. However, any transient signal induced by radiation hitting either of the AND gates 608A, 608B does not lead to a reset of either of the flip-flops 606A, 606B. Furthermore, a transient on only one of the outputs Q1 or Q2 will not cause a reset of the flip-flops 606A, 606B.

The output stage 604 comprises two redundant buffers 612A and 612A' receiving respectively the Q1 and Q2 data outputs from flip-flop 606A, and two redundant buffers 612B and 612B' respectively receiving the Q1 and Q2 data outputs from flip-flop 606B. Buffers 612A and 612A' respectively provide duplicated control signals UP1 and UP2, while buffers 612B and 612B' respectively provide duplicated control signals DN1 and DN2. The buffers 612A, 612A', 612B and 612B' may for example further comprise other combinational logic devices (not illustrated in Figure 6).

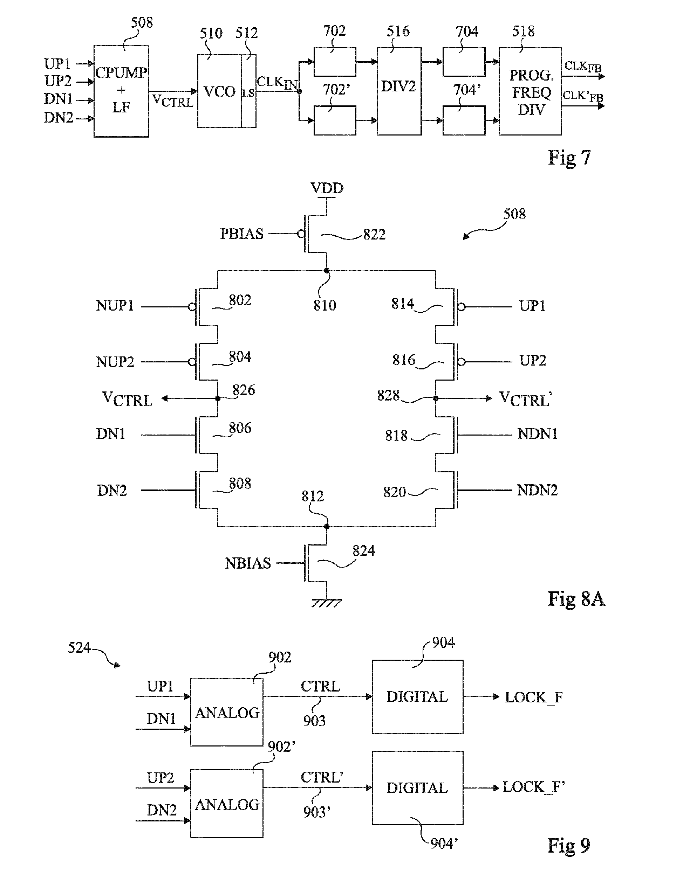

Figure 7 illustrates in more detail the feedback path from the charge pump 508 of the PLL through to the programmable frequency divider 518. The charge pump block 508 for example receives the duplicated control signals UP1, UP2, DN1 and DN2 generated by the phase frequency detector 506. As will be described in more detail below, this block for example comprises an analog circuit driven by digital clock signals, such that it is protected from a transient on the signal UP1 or UP2, or on the signal DN1 or DN2.

In one embodiment, all of the data connections linking the various blocks of the feedback path between the VCO 510 and the programmable frequency divider 518 are duplicated.

As illustrated in Figure 7, the signal CLK_{IN} from the VCO 510 is duplicated and provided to circuits 702 and 702', which are for example identical to each other or at least functionally equivalent. The circuits 702 and 702' for example comprise combinational logic such as data buffers and/or other logic gates.

Each of the circuits 702, 702' provides an output to a corresponding input of the divide-by-two block 516. This block for example comprises at least an input latch corresponding to the data storage element 302 described above, in which the data inputs are for example coupled to the inverted data storage outputs, to divide the input frequency by two, and the clock inputs CK1 and CK2 are for example coupled to the outputs of the circuits 702 and 702' respectively, such that any transient caused by radiation hitting the circuit 702 or 702' does not cause errors to be propagated further in the circuit.

The divide-by-two block 516 for example provides two identical output signals to corresponding circuits 704 and 704' respectively, which again for example comprises combinational logic. The circuits 704 and 704' each provide a signal to the programmable frequency divider 518. As with the divide-by-two block 516, the block 518 for example comprises at least an input latch corresponding to the data storage element 302 described above, such that any transient caused by radiation hitting the circuitry 704 or 704' does not cause errors to be propagated further in the circuit. The synchronous data storage elements of block 518 are for example protected from any transient in the circuits 704 or 704', by using the technique described above with reference to the data storage element 302 of Figure 3.

The programmable frequency divider 518 provides duplicated output signals CLK_{FB} and CLK'_{FB}, which are each provided to the phase frequency detector 506.

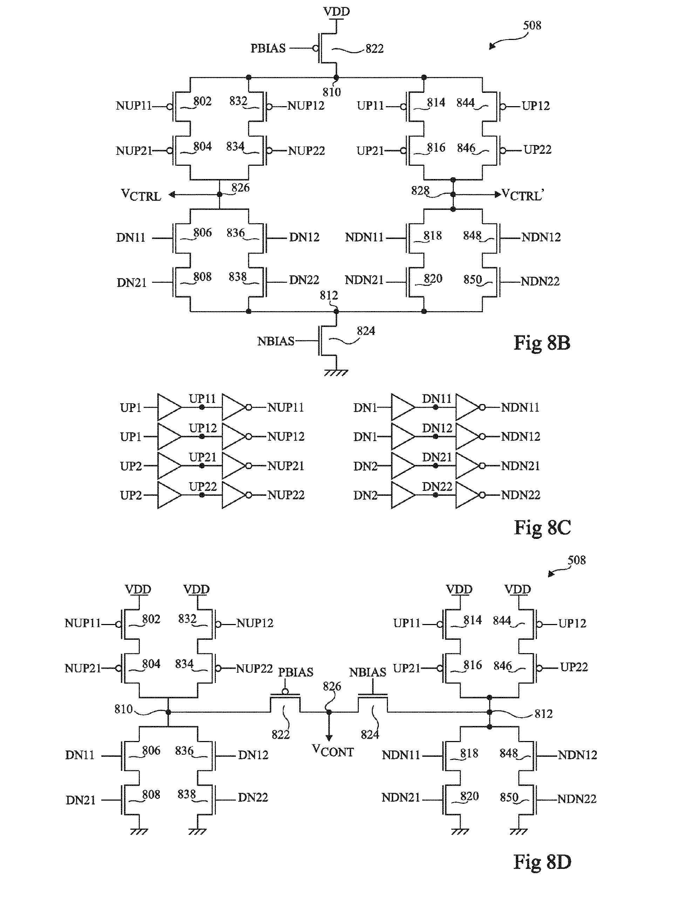

Figures 8A, 8B and 8D illustrate the charge pump 508 of Figure 7 according to an example embodiment. More generally, the circuits of Figures 8A, 8B and 8D provide examples of an analog implementation of the circuit block 102 of Figure 1.

As illustrated in Figure 8A, PMOS transistors 802, 804 and NMOS transistors 806, 808, are coupled in series by their main current nodes between nodes 810 and 812. Transistors 802 and 804 have their gates coupled to the inverse signals NUP1 and NUP2 of the up control signals UP1 and UP2 respectively, while transistors 806 and 808 have their gates coupled to the down control signals DN1 and DN2 respectively. A further two PMOS transistors 814, 816 and NMOS transistors 818, 820 are for example also coupled in series between nodes 810 and 812. Transistors 814 and 816 have their gates coupled to the signals UP1 and UP2 respectively, while transistors 818 and 820 have their gates coupled to the inverse signals NDN1 and NDN2 of the down control signals DN1 and DN2 respectively. Node 810 is for example coupled to a supply voltage VDD via a PMOS transistor 822 controlled at its gate node by a biasing voltage PBIAS. Furthermore, node 812 is for example coupled to ground via an NMOS transistor 824 controlled at its gate node by a biasing voltage NBIAS.

A node 826 between the PMOS transistor 804 and the NMOS transistor 806 provides an output signal V_{CTRL}, based on which the VCO is controlled. A node 828 between the PMOS transistor 816 and the NMOS transistor 818 provides an output signal V_{CTRL}', which may for example serve as a reference signal. Alternatively, the signal V_{CTRL}' is not used, the circuitry on the right-hand side in Figure 8B serving only the role of balancing. In some embodiments, transistors 814 to 820 could be omitted.

In operation, when both of the up control signals UP1 and UP2 go high, transistors 802 and 804 will be activated, increasing the voltage at node 826. When both of the down signals DN1 and DN2 go high, transistors 806 and 808 will be activated, decreasing the voltage at node 826. However, when only one of the signals UP1 and UP2, or only one of the signals DN1 and DN2, goes high, for example as a result of radiation, the output voltage VOUT will not be affected.

In a variant of Figure 8A, rather than being coupled in series with each other, the transistors 802 and 804 coupled be coupled in parallel between nodes 810 and 826, transistors 806 and 808 could be coupled in parallel between nodes 826 and 812, transistors 814 and 816 could be coupled in parallel between nodes 810 and 828, and transistors 818 and 820 could be coupled in parallel between nodes 828 and 812. An advantage of such a variant is that, when both the parallel transistors are conducting and a transient causes one of these transistors to stop conducting, current flow is maintained by the other transistor.

Figure 8B illustrates the charge pump 508 according to an alternative example similar to that of Figure 8A, and in fact includes all of the elements of Figure 8A, which have been labelled in Figure 8B with the same reference numbers. Additionally, the circuit of Figure 8B comprises: PMOS transistors 832 and 834 coupled in series between nodes 810 and 826, in parallel with transistors 802 and 804; NMOS transistors 836 and 838 coupled in series between nodes 826 and 812, in parallel with transistors 806 and 808; PMOS transistors 844 and 846 coupled in series between nodes 810 and 828, in parallel with transistors 814 and 816; and NMOS transistors 848 and 850 coupled in series between nodes 828 and 812, in parallel with transistors 818 and 820. The transistors 802, 804, 832 and 834 are controlled by signals NUP11, NUP21, NUP12 and NUP22 respectively. The transistors 806, 808, 836 and 838 are controlled by signals DN11, DN21, DN12 and DN22 respectively. The transistors 814, 816, 844 and 846 are controlled by signals UP11, UP21, UP12 and UP22 respectively. The transistors 818, 820, 848 and 850 are controlled by signals NDN11, NDN21, NDN12 and NDN22 respectively.

Figure 8C illustrates an example of circuitry for generating the various control signals of Figure 8B.

For example, the input signal UP1 is buffered by a buffer to generate the signal UP11, which is in turn inverted by an inverter to generate the signal NUP11. The signal UP1 is also buffered by another buffer to generate signal UP12, which is then inverted by another inverter to generate the signal NUP12.

Similarly, the input signal UP2 is buffered by a buffer to generate the signal UP21, which is in turn inverted by an inverter to generate the signal NUP21. The signal UP2 is also buffered by another buffer to generate signal UP22, which is then inverted by another inverter to generate the signal NUP22.

Similarly, the input signal DN1 is buffered by a buffer to generate the signal DN11, which is in turn inverted by an inverter to generate the signal NDN11. The signal DN1 is also buffered by another buffer to generate signal DN12, which is then inverted by another inverter to generate the signal NDN12.

Similarly, the input signal DN2 is buffered by a buffer to generate the signal DN21, which is in turn inverted by an inverter to generate the signal NDN21. The signal DN2 is also buffered by another buffer to generate signal DN22, which is then inverted by another inverter to generate the signal NDN22.

With reference again to Figure 8B, operation of the circuit is similar to that of Figure 8A, except that the new transistors 832 to 838 and 844 to 850 provide additional protection against radiation hitting the transistors 802 to 808 and 814 to 820. Furthermore, the circuit is protected from radiation hitting any one of the buffers of inverters of Figure 8C.

Figure 8D illustrates the charge pump 508 according to yet a further embodiment. Whereas Figure 8B provides an example of a drain switching embodiment, Figure 8D provides an example of a source switching embodiment. This embodiment comprises the same transistors as the embodiment of Figure 8B, controlled by the same controlled signals, which are for example also generated by the circuitry of Figure 8C. However, the transistors in Figure 8D are arranged differently, with the transistor pair 802, 804, and the transistor pair 832, 834, coupled between supply voltage V_{DD} and node 810. Similarly, the transistor pair 806, 808, and the transistor pair 836, 838, are coupled between ground and node 810. Furthermore, the transistor pair 814, 816, and the transistor pair 844, 846, are coupled between supply voltage V_{DD} and node 812. Furthermore, the transistor pair 818, 820, and the transistor pair 848, 850, are coupled between ground and node 812. Node 810 is coupled to the output node 826 via PMOS transistor 822, and node 812 is coupled to the output node 826 via NMOS transistor 824.

Operation of the circuitry of Figure 8D is similar to that of Figure 8B.

Figure 9 illustrates an example of the analog lock detection block 524 according to an example embodiment.

As illustrated, the block 524 for example comprises duplicated analog portions 902 and 902'. The analog portion 902 receives the control signals UP1 and DN1 from the phase frequency detector 506, while the analog portion 902' receives the control signals UP2 and DN2 from the phase frequency detector 506. The analog portions 902 and 902' detect, based on the control signals, when the input signals have stabilized, and provides corresponding redundant digital lock control signals CTRL and CTRL' on two output lines 903 and 903' respectively. The signal CTRL is provided to a digital portion 904, while the signal CTRL' is provided to a digital portion 904'. The digital portions 904 and 904' are for example identical to each other or at least functionally equivalent, and comprise combinational and/or sequential logic. These blocks provide respective lock signals LOCK_F and LOCK_F', which are for example provided to a data storage element similar to element 102 or 302 described above, which is outside the PLL.

The example of Figure 9 demonstrates that analog portions of a circuit may be duplicated in addition to the digital portions in order to protect the analog portions from the effects of radiation.

An advantage of the embodiments described herein is that a circuit block is protected from radiation hitting input circuitry at one or more of its inputs in a simple and effective manner. For example, an output of the circuit block is determined by the conduction state of transistors respectively controlled by duplicated input signals, such that one of the transistors will counter to some extent a change caused by a transient affecting the other transistor. It is particularly preferable in certain cases that the digital data paths, clock paths and low capacitance analog nodes are protected. Protection of the clock paths can be achieved in a simple fashion by clocking a first version of the data signal with a first version of the clock signal, and a second version of the data signal with a second version of the clock signal. Protection of low capacitance analogue parts can be achieved in a simple fashion by duplicating these parts, and providing the duplicated signals to a data storage element as described above.

Having thus described at least one illustrative embodiment of the invention, various alterations, modifications and improvements will readily occur to those skilled in the art.

For example, while in the circuits represented in the various Figures, the high and low supply voltages are at V_{DD} and ground, it will be apparent that any suitable voltages could be used, which may depend on the transistor technology.

Furthermore, it will be apparent to those skilled in the art that the transistors represented as p-channel MOS transistors could be replaced in alternative embodiments by n-channel MOS transistors, and vice versa. Furthermore, the various transistors could be implemented in alternative transistor technologies rather than MOS, such as bipolar.

Furthermore, various features of the circuit of Figure 4, such as the reset transistors 404A, 413, 404C and 418 could be omitted in alternative embodiments, as well as the transistors 404B, 404D, 410B and 410D receiving the clock signals.

Furthermore, while one example of a phase locked loop circuit has been provided in Figure 5, it will be apparent to those skilled in the art that there are numerous modifications that could be applied to this circuit. For example, the divide-by-two block 516 and/or level shifter 512 could be omitted in some embodiments.

Furthermore, while the various synchronous devices described herein have been described as being responsive to rising edges of the clock signal, it will be apparent to those skilled in the art that any device could be adapted to be responsive to falling edges.

Furthermore, while the analog portions 508 and 510 of Figure 7 are not duplicated, in alternative either or both of these portions could be duplicated to provide added protection.

## Claims

1. A circuit comprising:
a data storage element (102);
first input circuitry (104) coupled to a first input (IN1) of the data storage element and comprising a first plurality of components adapted to generate, as a function of an initial signal (IN), a first input signal provided to said first input;
second input circuitry (104') coupled to a second input (IN2) of the data storage element and comprising a second plurality of components adapted to generate, as a function of said initial signal (IN), a second input signal provided to said second input, the second input circuitry being functionally equivalent to the first input circuitry;
wherein the data storage element comprises a first storage node (412), and wherein said data storage element is configured such that a voltage state stored at said first storage node is protected from a change in only one of said first and second input signals by being determined by the conduction state of a first transistor (406A) coupled to the first storage node and controlled based on said first input signal and by the conduction state of a second transistor (408A) coupled to the first storage node and controlled based on said second input signal.

2. The circuit of claim 1, wherein:
said first transistor (406A) is coupled by its main current nodes between said first storage node and a first supply voltage (V_{DD}) and has its control node coupled to said first input; and
said second transistor (408A) is coupled by its main current nodes between said first storage node and a second supply voltage (GND) and has its control node coupled to said second input.

3. The circuit of claim 2, further comprising a second storage node (416) configured to store a voltage state determined by the conduction state:
of a third transistor (406C) coupled between the second storage node and the first supply voltage (V_{DD}) and controlled based on said first input signal; and
of a fourth transistor (408C) coupled between the second storage node and said second supply voltage (GND) and controlled based on said second input signal.

4. The circuit of claim 3, further comprising:
a third storage node (414) coupled: to said control node of said first transistor; to said first supply voltage (V_{DD}) by the main current nodes of a fifth transistor (406B); and to said second supply voltage (GND) by the main current nodes of a sixth transistor (410B), a control node of the fifth transistor being coupled to the second storage node and a control node of the sixth transistor being coupled to the first storage node; and
a fourth storage node (420) coupled: to said control node of said second transistor; to said first supply voltage (V_{DD}) by the main current nodes of a seventh transistor (406D); and to said second supply voltage (GND) by the main current nodes of an eighth transistor (408D), a control node of the seventh transistor being coupled to the first storage node and a control node of the eighth transistor being coupled to the second storage node.

5. The circuit of any of claims 1 to 4, wherein said first and second input signals are each one of:
a data signal (D1, D2);
a clock signal (CLK1, CLK2);
a reset signal (R1, R2); and
a set signal (S1, S2).

6. The circuit of any of claims 1 to 5, wherein said data storage element (102) is a synchronous data storage element, the first and second inputs being data inputs of said synchronous data storage element, and wherein the control node of said first transistor is coupled to said first input via a first switch (415) controlled by a first clock signal (CK1), and the control node of said second transistor is coupled to said second input via a second switch (421) controlled by a second clock signal (CK2).

7. The circuit of claim 6 further comprising:
first clock input circuitry (304) coupled to a first clock input (CK1) of said synchronous data storage element (102) and adapted to provide a first clock signal to said first clock input based on an initial input clock signal (CK);
second clock input circuitry (304') coupled to a second clock input (CK2) of said synchronous data storage element (102) and adapted to provide a second clock signal to said second clock input based on said initial input clock signal (CK).

8. The circuit of any of claims 1 to 7, wherein said data storage element is a synchronous data storage element, said first input being a first clock input and said second input being a second clock input, and wherein:
the control node of said first transistor (406A) is coupled to one of the main current nodes of a ninth transistor (404B, 410B), a control node of said ninth transistor being coupled to said first clock input; and
the control node of said second transistor (408A) is coupled to one of the main current nodes of a tenth transistor (404D, 410D), a control node of said tenth transistor being coupled to said second clock input.

9. A circuit comprising:
an analog circuit block (102);
first input circuitry (104) coupled to a first input of the analog circuit block and comprising a first plurality of components adapted to generate, as a function of an initial signal (UP, DN), a first input signal (UP1, NUP1, DN1, NDN1) provided to said first input;
second input circuitry (104') coupled to a second input of the analog circuit block and comprising a second plurality of components adapted to generate, as a function of said initial signal (UP, DN), a second input signal (UP2, NUP2, DN2, NDN2) provided to said second input, the second input circuitry being functionally equivalent to the first input circuitry;
wherein the analog circuit block comprises an output node (826, 828), said output node being protected from a change in only one of said first and second input signals by being coupled to a first supply voltage (V_{DD}) via first and second transistors (802, 804, 832, 834) and to a second supply voltage (GND) via third and fourth transistors (806, 808, 836, 838), said first and third transistors being controlled based on said first input signal, and said second and fourth transistors being controlled based on said second input signal.

10. The circuit of claim 9, wherein said analog circuit block is a charge pump.

11. The circuit of claim 9 or 10, wherein said first and second transistors are coupled in series with each other, and wherein said third and fourth transistors are coupled in series with each other.

12. The circuit of claim 9 or 10, wherein said first and second transistors are coupled in parallel with each other, and wherein said third and fourth transistors are coupled in parallel with each other.

13. A phase locked loop (PLL) comprising the circuit of any of claims 1 to 12.

14. A method of protecting first input circuitry of a data storage element (102) from radiation comprising:
generating, by the first input circuitry (104) comprising a first plurality of components, a first input signal (IN1) as a function of an initial signal (IN);
generating, by second input circuitry (104') comprising a second plurality of components, a second input signal (IN2) as a function of said initial signal, the second input circuitry being functionally equivalent to the first input circuitry; and
wherein a voltage state stored by a first storage node (412) of said data storage element is protected from a change in only one of said first and second input signals by being determined by the conduction state of a first transistor coupled to the first storage node and controlled based on said first input signal and of a second transistor coupled to the first storage node and controlled based on said second input signal.

15. A method of protecting first input circuitry of an analog circuit block (102) from radiation comprising:
generating, by the first input circuitry (104) comprising a first plurality of components, a first input signal (UP1, NUP1, DN1, NDN1) as a function of an initial signal (UP, DN);
generating, by second input circuitry (104') comprising a second plurality of components, a second input signal (UP2, NUP2, DN2, NDN2) as a function of said initial signal, the second input circuitry being functionally equivalent to the first input circuitry; and
generating an output signal (OUT) at a first output node (110) of the analog circuit block, wherein said output signal is protected from a change in only one of said first and second input signals by being coupled to a first supply voltage (V_{DD}) via first and second transistors (802, 804, 832, 834) and to a second supply voltage (GND) via third and fourth transistors (806, 808, 836, 838), said first and third transistors being controlled based on said first input signal, and said second and fourth transistors being controlled based on said second input signal.
